# EUROPEAN PATENT APPLICATION

(11) **EP 2 779 243 A1**
(43) Date of publication of application: **17.09.2014**
(21) Application number: 13158958.2
(22) Date of filing: 13.03.2013
(51) Int. Cl.: H01L 29/745, H01L 29/749, H01L 29/06, H01L 29/10

(54) **Power semiconductor device and corresponding module**

(71) Applicant: ABB Technology AG, 8050 Zürich (CH)
(72) Inventor: Rahimo, Munaf, 5619 Uezwil (CH)
(74) Representative: ABB Patent Attorneys

(57) **Abstract**

A power semiconductor device (1) of the emitter switched thyristor (EST) type comprising an emitter electrode (2) and a collector electrode (25) on opposite sides (22, 27) of a wafer (10),
wherein a gate electrode (7) arranged on the emitter side (22) comprises a conductive gate layer (72) and an insulating layer (74),
wherein layers are arranged in the following order between the collector and emitter sides (27, 22):
a p doped collector layer (6), an n- doped drift layer (5), a p doped base layer (4) and n+ doped first and second emitter layers (3, 35),
wherein the emitter electrode (2) contacts the first emitter layer (3), wherein the second emitter layer (35) is insulated from the emitter electrode (2) by the insulating layer (74) and wherein the second emitter layer (35) is separated from the first emitter layer (3) by the base layer (4),
wherein an IGBT channel (100) is formable from the first emitter layer (3) via the base layer (4) to the drift layer (5),
wherein a thyristor channel (120) is formable from the second emitter layer (35) via the base layer (4) to the drift layer (5),
wherein a MOS channel (140) is formable from first emitter layer (3) via the base layer (4) to the second emitter layer (35).

## Description

### Technical Field

The invention relates to the field of power electronics and more particularly to a power semiconductor device.

### Background Art

### Modes for Carrying out the Invention

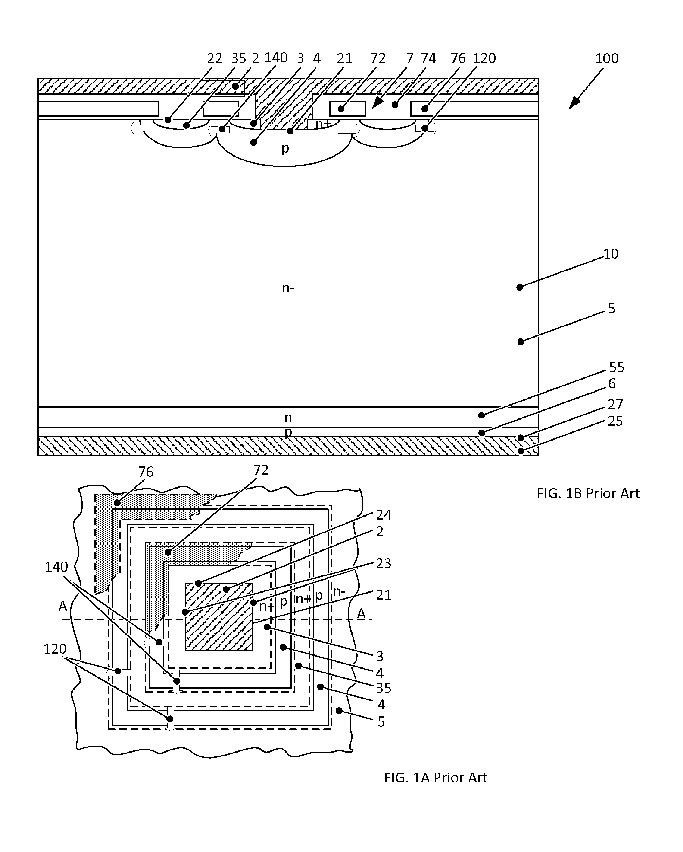

In FIG 1 A and B an emitter switched thyristor (EST) 100 is shown, which comprises a wafer 10 having an emitter and a collector side 22, 27, on which sides an emitter electrode 2 and a collector electrode 25 are arranged. On the emitter side 22, a planar or trench gate electrode 7 is arranged, which comprises an electrically conductive gate layer 72, a further gate layer 76 and an insulating layer 74, which insulates the gate layer 72 and 76 from any layer of the first or second conductivity type in the wafer 10 and from each other. FIG 1A shows a top view on the device 100, whereas FIG 1 B shows a cut along the line A -- A in FIG 1A.

Like in an IGBT, on the emitter side 22, an n doped first emitter layer 3, which extends to a region below the gate layer 72 and a p doped base layer 4 surrounding the first emitter layer 3 are arranged. The first emitter layer 3 and the base layer 4 contact the emitter electrode 2 at an emitter contact area 21. The device further comprises on the emitter side 22 a second n doped emitter layer 35, which is insulated from the emitter electrode 2 by the insulating layer 74. The second emitter layer 35 extends from a region below the gate layer 72 to a region below a further gate layer 76, which completely surrounds the gate layer 72. Towards the collector electrode 25, a lowly (n-) doped drift layer 5 and a p doped collector layer 6 are arranged.

In this device, a MOS channel 140 is formable form the first emitter layer 3 via the base layer 4 to the second emitter layer 35. In the device, another channel in form of a thyristor channel 120 is formable during operation from the second emitter layer 35 via the base layer 4 to the drift layer 5.

The EST uses a cascade concept, in which a low voltage MOSFET is integrated in series with a thyristor structure, such that by turning off the MOSFET, the thyristor is turned off. Due to the shorted base layer the EST provides a MOS voltage controlled turn-on switching, a higher diode safe operating area and handling fault conditions when compared to the IGCT. Such a device has limited short circuit capability depending on its low voltage MOSFET blocking and higher on-state snapback effects.

Also the on-state losses are higher due to the low voltage MOSFET channel resistance than for a prior art IGCT. The base layer is shorted in the EST devices, so that the thyrsitor structure enhancement effect is reduced due to hole drainage, and hence this results in higher on-state losses. The on-state suffers from a snapback effect before the thyristor areas are latched since conduction occurs initially through the two channels.

### Disclosure of Invention

It is an object of the invention to provide a power semiconductor device, which provides lower losses, while having good MOS controllability and higher safe operating area than prior art devices, in particular EST devices.

This object is achieved by providing an inventive power semiconductor device comprising a wafer, on which an emitter electrode is arranged on an emitter side of the wafer and a collector electrode is arranged on a collector side of the wafer opposite to the emitter side. In the wafer, various layers of a first or of a second conductivity type, which is different from the first conductivity type, are arranged.

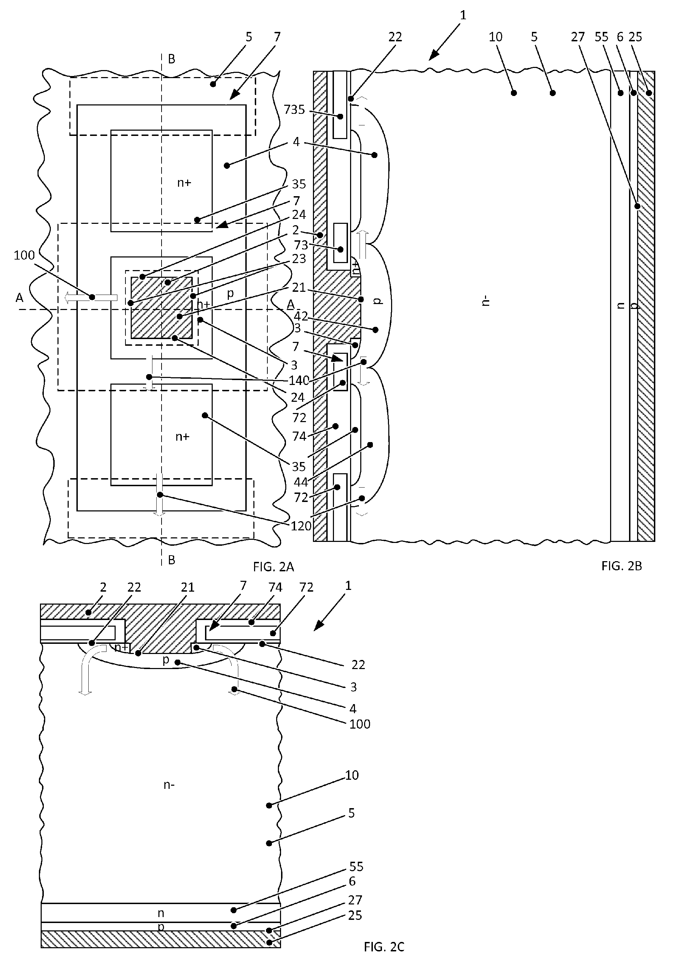

As shown in FIG 2A, the wafer comprises layers in the following order from the collector side towards the emitter side: a collector layer of the second conductivity type, a lowly doped, exemplarily uniformly doped drift layer of the first conductivity type, a base layer of the second conductivity type and a first and a second emitter layer of the first conductivity type.

A planar gate electrode is arranged on the emitter side, which gate electrode comprises an electrically conductive gate layer and an insulating layer, which insulates the gate layer from any layer of the first or second conductivity type in the wafer.

Both first and second emitter layers are arranged at the emitter sided surface of the wafer between the base layer and the emitter electrode. The first emitter layer as well as the base layer contact the emitter electrode at an emitter contact area. Both emitter layers are separated from the drift layer and from each other by the base layer. The second emitter layer is differently from the first emitter layer not in contact to the emitter electrode, but insulated from it by the insulating layer.

In the device, three different channels are formable during operation of the device. An IGBT channel is formable from the first emitter layer via the base layer to the drift layer, i.e. charges can flow from the emitter electrode to the drift layer. The second channel is a thyristor channel, which is formable from the second emitter layer via the base layer to the drift layer. The third channel is a MOS channel, formable from first emitter layer via the base layer to the second emitter layer. Depending on the design of the layers, the channels can be formed at different locations.

Thus, the inventive device incorporates an IGBT structure and an EST structure in one device. The channels can be formed in different directions, e.g. the MOS and thyristor channel can be formed in a first direction and the IGBT channel can be formed in another direction, exemplarily perpendicular to the first direction in a plane parallel to the emitter side. Any other arrangement of the channels can also be realised as exemplarily MOS and IGBT channels can be arranged parallel to each other and the thyristor channel is arranged in another direction.

FIG 2B shows a cut of the device along the line B --B shown in FIG 2A. In this cut, a thyristor and a MOS channel as known from the prior art EST devices (FIG 1) are shown. However, in a cut perpendicular to the cut of FIG 2B, i.e. along the line A -- A the device comprises an IGBT channel. This channel does not exist in the prior art EST device, because the gate layer and the emitter layers are arranged in such devices in a closed shape around the emitter contact area so that this device only has MOS and thyristor channels (FIG 1 B).

Due to the introduction of additional IGBT channel the device has less drainage effect and the IGBT and Thyristor sections can be optimized independently depending on the electrical and geometrical requirements. The parallel IGBT provides options for gate driving and improved turn-off capability. Also the MOS channel can be designed independently so that the device provides low losses.

Due to the different channels, the device provides a high level of carrier enhancement at the emitter and lower hole drainage, hence the on state losses are reduced.

The inventive structure of the three different IGBT, MOS and thyristor channels can be integrated into various different semiconductor devices like punch-through devices (having a highly doped buffer layer of the first conductivity type arranged between the drift layer and the collector layer) and non punch-through devices (which do not have such a buffer layer, i.e. at which the drift layer contacts the collector layer), reverse conducting devices (at which in the plane of the collector layer the collector layer alternates with a highly doped layer of the first conductivity type), optimization of the geometrical structures of the layers as to form exemplarily cell or strip shapes. If desired, the doping concentrations of the first and second emitter layers and the base layer below these emitter layers can be adapted independently, as to achieve different threshold voltages for the MOS and the IGBT channel. The device may also comprise pure diode sections for bimode operation.

A highly doped enhancement layer can be integrated into the IGBT section without influencing the MOS and thyristor section so that the IGBT charge enhancement and high latch up immunity is improved. In the IGBT section, also a highly doped p contact layer can be integrated, at which the emitter electrode contact the p doped layer for improvement of electrical properties and especially the safe operating area.

The size of each IGBT, MOS and thyristor sections and the ratio of the sizes to each other can be optimized.

Furthermore, the device can be manufactured using self-aligned masks for the emitter sided layers.

### Brief Description of Drawings

The subject matter of the invention will be explained in more detail in the following text with reference to the attached drawings, in which:
FIG 1A and B shows a prior art EST device;
FIGs 2 to 6A-C show in the figures A top views on various inventive power semiconductor devices, in the figures B and C cuts along the line A -- A and B -- B;
FIGs 7 to 14 shows top views on various inventive semiconductor devices and
FIG 15 a cut along the line B -- B through another inventive power semiconductor device.

The reference symbols used in the figures and their meaning are summarized in the list of reference symbols. Generally, alike or alike-functioning parts are given the same reference symbols. The described embodiments are meant as examples and shall not confine the invention.

### Modes for Carrying out the Invention

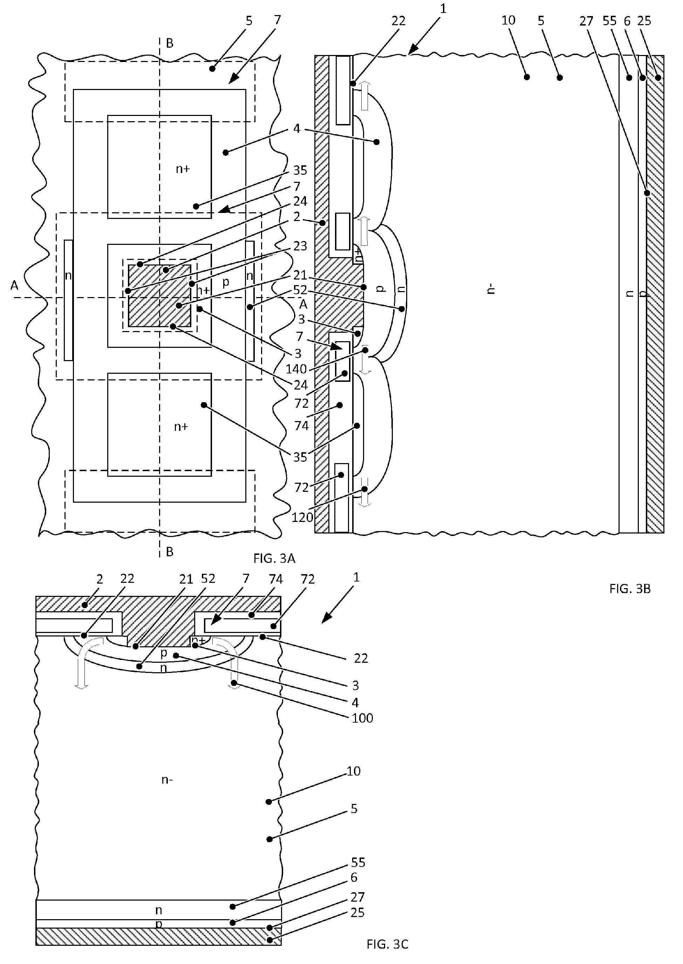

An inventive power semiconductor device 1 as shown in FIG 2 comprises a wafer 10, on which wafer 10 an emitter electrode 2 is arranged on an emitter side 22 of the wafer and a collector electrode 25 is arranged on a collector side 27 of the wafer opposite to the emitter side 22. FIG 2A shows a top view on the device 1, whereas FIG 2 B shows a cut along the line B -- B in FIG 2A and FIG 2C shows a cut along the line A -- A in FIG 2A. The figures 3 to 6 show the same views for different inventive devices.

The wafer comprises n and p doped layers between the collector side 27 and the emitter side 22 in the following order: a p doped collector layer 6, a lowly (n-) doped drift layer 5, a p doped base layer 4 and first and second highly n doped emitter layers 3, 35.

The first and second highly doped emitter layers 3, 35 are arranged at the emitter sided surface of the wafer in the same plane. The emitter layers 3, 35 are highly doped such that they have higher doping concentration than the drift layer 5. Exemplarily, the emitter layers 3, 35 have the same maximum doping concentration. The emitter layers 3, 35 may be formed as diffused layers, i.e. have a maximum doping concentration, beyond which (i.e. towards greater depths in the wafer) the doping concentration decreases. The first emitter layer 3 as well as the base layer 4 contact an emitter electrode 2 at an emitter contact area 21. Exemplarily, the first emitter layer 3 is a self-contained, i.e. closed layer, which surrounds the emitter contact area 21 laterally, i.e. in a plane parallel to the emitter side 22.

The base layer 4 is arranged between the drift layer 5 and the emitter electrode 2. The base layer 4 separates the emitter layers 3, 35 from the drift layer 3. Additionally, the base layer 4 separates the first and second emitter layer 3, 35 from each other. The base layer 4 extends to the emitter sided surface of the wafer between the first and second emitter layers 3, 35. The base layer 4 also extends to the emitter sided surface of the wafer between the second emitter layer 35 and the drift layer 5.

The base layer 4 may also comprise a first base region 42 at the emitter contact area 21 to an area below the first emitter layer 3 and a second base region 44 extending below the area of the second emitter layer 35 and may extend to an area below the gate layer 72 at the thyristor channel 120. In such an inventive device, the maximum doping concentrations of the first and second base region, i.e. the first and second maximum doping concentrations, can be adapted independently. E.g. the second maximum doping concentration of the second base region can be chosen to be lower than the first maximum doping concentration of the first base region in order to improve the thyristor latch-up capability, i.e. the device latches up at the thyristor channel 120 at lower currents than in a device, in which the first and second maximum doping concentrations are the same. In an exemplary embodiment, the first maximum doping concentration may be between 1 * 10¹⁷ cm⁻³ and 1 * 10¹⁸ cm⁻³. The second maximum doping concentration may be between 1 * 10¹⁶ cm⁻³ and 1 * 10¹⁷ cm⁻³; exemplarily the second maximum doping concentration is by a factor of 2 to 10 smaller than the first maximum doping concentration. In another exemplary embodiment, the first and second base regions 42, 44 have the same maximum doping concentrations. A planar gate electrode 7 is arranged on the emitter side 22, which gate electrode 7 comprises an electrically conductive gate layer 72 and an insulating layer 74, which insulates the gate layer 72 from any layer of the first or second conductivity type in the wafer 10. The gate layer 72 is arranged on the emitter sided surface of the wafer 10 laterally to the emitter contact area 21. It extends to an area above the base layer 4, the first emitter layer 3 and the second emitter layer 35 as well as the drift layer 5. Depending on the design of the inventive device, the gate layer 72 may comprise a first and second electrically conductive layer 73, 735' (only indicated in FIG 2B). The first electrically conductive layer 73 may be formed as a closed layer, which surrounds an emitter contact area 21 and which is laterally limited to an area above the first emitter layer 3, extends through an area, at which the base layer 4 extends to the emitter sided surface of the wafer between the first and second emitter layer 3, 35 further to an area above the second emitter layer 35. A second electrically conductive layer 735' may be formed from an area above the second emitter layer 35, extends through another area, at which the base layer 4 extends to the emitter sided surface of the wafer at the thyristor channel 120 further to an area at which the drift layer 5 extends to the emitter sided surface of the wafer. The first and second electrically conductive layers 73, 735' are separated from each other by the insulating layer 74. Depending on the design, there also may be just one gate layer 72 used for creating a MOS, IGBT and thyristor channel 100, 120, 140.

The emitter electrode 2 contacts the base layer 4 and the first emitter layer 3 at the emitter contact area 21. The second emitter layer 35 is insulated from a contact to the emitter electrode 2 by the insulating layer 74. Thus, the second emitter layer 35 is not in touch with the emitter electrode 2 or any other controllable electrode. Still, the MOS channel is formed from the first to the second emitter layer 3, 35.

In such a device, three different sorts of channels are present. For clarity reasons, the channels are not shown in all figures. An IGBT channel 100 is formable from the first emitter layer 3 via the base layer 4 to the drift layer 5 (e.g. shown in FIG 2C). At the IGBT channel 100, the drift layer 5 extends to the emitter sided surface of the wafer below the same gate layer 72, below which the first emitter layer 3 is arranged (i.e. the first emitter layer 3 extends to a region below the same gate layer 72, below which the drift layer 5 extends to).

A thyristor channel 120 is formable from the second emitter layer 35 (which is not connected to the emitter electrode 2) via the base layer 4 to the drift layer 5. At the thyristor channel 120, the drift layer 5 extends to the emitter sided surface of the wafer below the gate layer 72.

A MOS channel 140 is formable from first emitter layer 3 via the base layer 4 to the second emitter layer 35 (e.g. shown in FIG 2B). A single gate layer 72 extends at the MOS channel 140 from a region above the first emitter layer 3 to a region above the second emitter layer 35 with the base layer 4 in between. No drift layer extends at the MOS channel 140 (i.e. between the first and second emitter layer 3, 35) to the emitter sided surface of the wafer.

Additionally to the above mentioned layers, a highly doped n doped enhancement layer 52 may be arranged between the base layer 4 and the drift layer 5 (FIG 3, 4 and 6). The enhancement layer 52 separates the base layer 4 from the drift layer 5. Exemplarily, the drift layer 5 has a constantly low doping concentration and the enhancement layer 52 has a higher doping concentration than the drift layer 5. Therein, the substantially constant doping concentration drift layer means that the doping concentration is substantially homogeneous throughout the drift layer, however without excluding that fluctuations in the doping concentration within the drift layer being in the order of a factor of one to five may be possibly present due to e.g. a manufacturing process of the wafer being used. The enhancement layer 52 may be a diffused layer having a maximum doping concentration, wherein the doping concentration decreases steadily from the depth of maximum doping concentration towards greater depths in the wafer from the emitter side 22 in a central part of the enhancement layer 52 (below the emitter contact area 21). The enhancement layer 52 may exemplarily have a maximum doping concentration between 5 * 10¹⁵ cm⁻³ and 2 * 10¹⁶ cm⁻³. An exemplary doping concentration of the drift layer 5 is between 5 *10¹² cm⁻³ and 1.5 * 10¹⁴ cm⁻³.

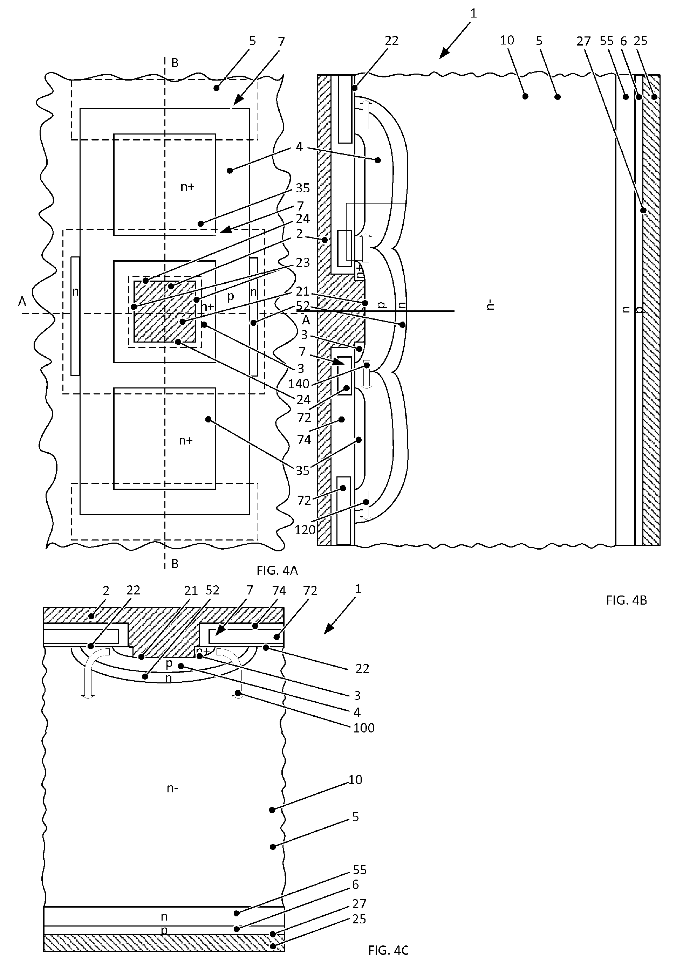

The enhancement layer 52 may be formed such that it completely separates the p doped base layer 4 from the n- doped drift layer 5 (FIG 4). In another embodiment, the enhancement layer 52 may be arranged only in the IGBT part of the device, i.e. below the emitter contact area 21 and surrounding the emitter contact area 21 up to the regions at which the IGBT channel is formed (FIG 3), but does not extend to the area below the second emitter layer 35 so that the thyristor and MOS channels 120, 140 are not influenced by the enhancement layer 52.

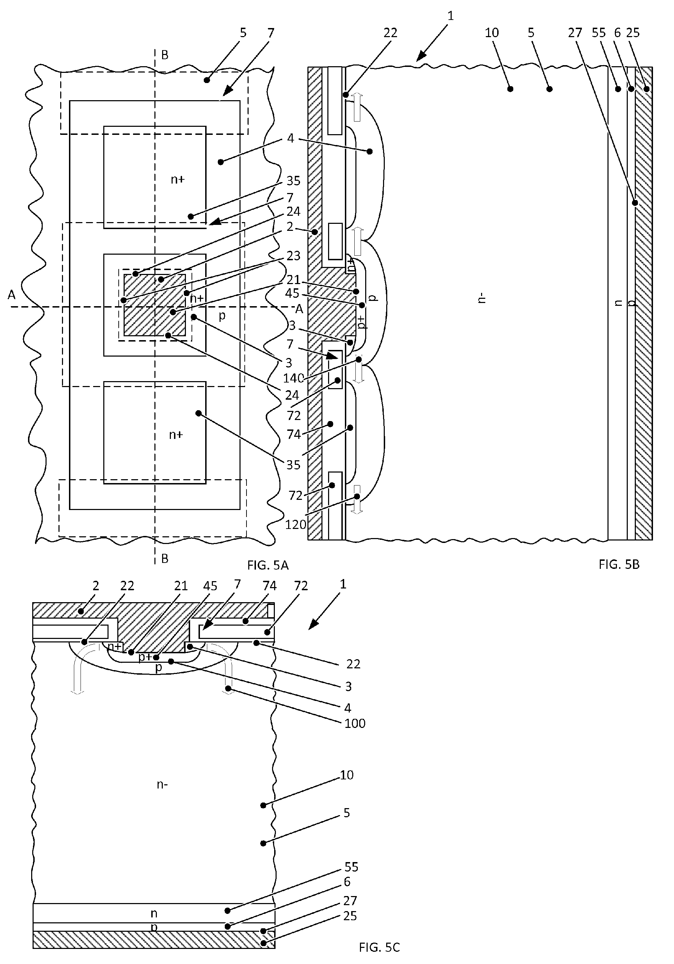

In FIG 5 another inventive embodiment is shown, in which the device 1 comprises a highly p+ doped contact layer 45, which is arranged in between the emitter contact area 21 and the p base layer 4 in order to have a highly doped interlayer at the contact to the emitter electrode 2. The p contact layer 45 may be limited to the area at which a p doped layer is in contact to the emitter electrode 2, i.e. at the emitter contact area 21.

The contact layer 45 may have a maximum doping concentration between 5x10¹⁸ /cm³ and 5x10¹⁹ /cm³ whereas the base layer 4 exemplarily has a maximum doping concentration between 1x10¹⁷ /cm³ and 1x10¹⁸ /cm³. The contact layer and base layer 4, 45 may be formed as diffused layers, i.e. as overlaid layers, in which the doping concentration of each layer decreases, but the contact layer 45 is arranged up to a first depth, which is smaller than the depth of the base layer (measured from the emitter side 22). The layers 4, 45 overlap such that at the cross point a discontinuous decrease of the doping concentration is present.

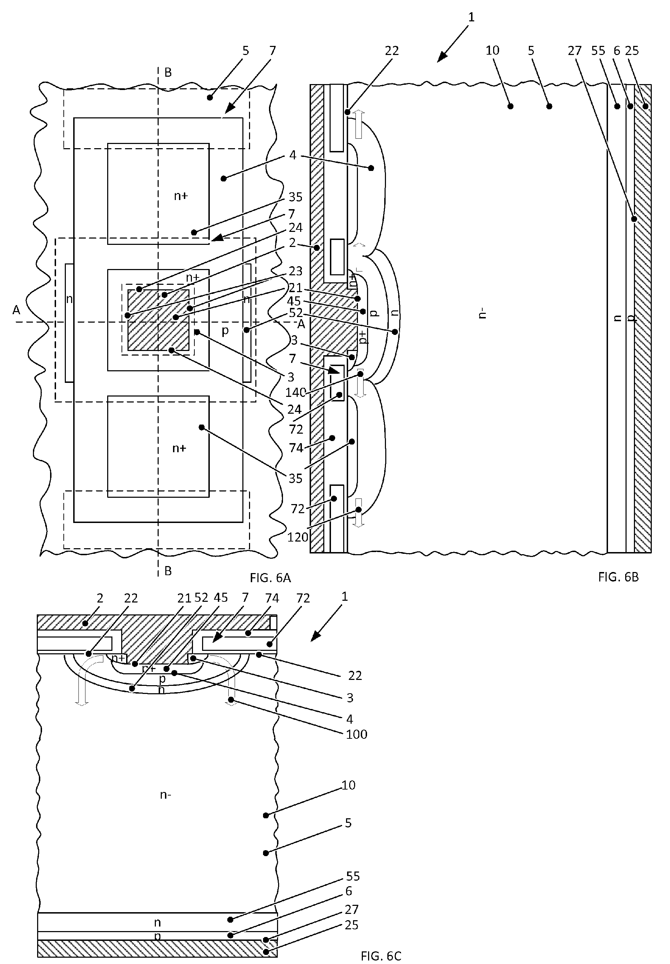

Of course, also elements of the disclosed inventive elements can be combined. For example, as shown in FIG 6, the device may comprise a p contact layer together with an enhancement layer 52, the enhancement layer 52 exemplarily being arranged below the emitter contact area 21.

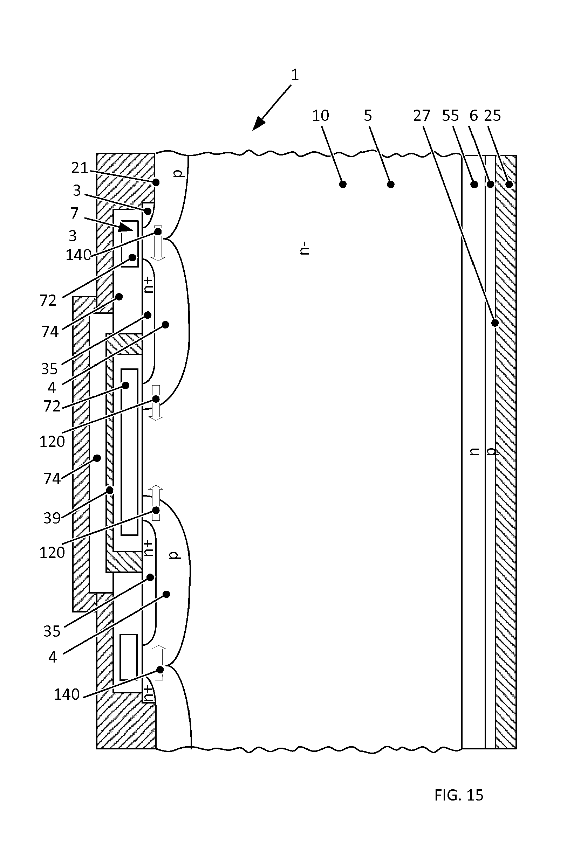

A power semiconductor module may be formed by at least two semiconductor devices 1, which are arranged on a common wafer 10, wherein the devices are exemplarily arranged in a regular manner. Exemplarily, the devices are arranged such that the device shown in the figures 2B to 6B are arranged repetitively. Such a module comprises at least two second emitter layers 35 and it may also comprise an electrically conductive connection layer (39), which electrically connects the at least two second emitter layers (35) of the at least two power semiconductor devices with each other. FIG 15 shows such an inventive device, which is a cut through an inventive device along a line corresponding to line B - B of FIG 2A, but at a shifted section. The connection layer 39 is arranged on the wafer 10. Such a connection layer 39 may be formed above and contacts the second emitter layers 35 belonging to two neighbored devices 1. The connection layer is electrically insulated from the emitter electrode 2 (or any other electrode) and the gate layer 72 by the insulating layer 74. The connection layer 39 is, therefore, a floating layer, which may be formed of a metal. Such a connection layer 39 enhances the current distribution between the two connected thyristor regions, and thus improves the electrical properties of the device.

The emitter contact area 21 may comprise in a plane parallel to the emitter side 22 two first sides 23 opposite to each other, wherein the IGBT channel 100 is formable at the two first sides 23 of the emitter contact area 21, what shall mean that the channel is formed at such part of the first emitter layer 3, to which the first sides 21 are neighbored (closest side to the first emitter layer 3). Thus, IGBT channels 100 are formable at two opposite sides of the emitter contact are 21. The term that the channel is formed "at a side" of the emitter contact area 21 shall not mean that the channel is formed through the first side, but it is formed from a region of the first emitter layer 3, which are in touch with the appropriate side, i.e. the channel is formed from such part of the first emitter layer 3, which is arranged between the appropriate side and such part of the drift layer 5, to which the channel extends.

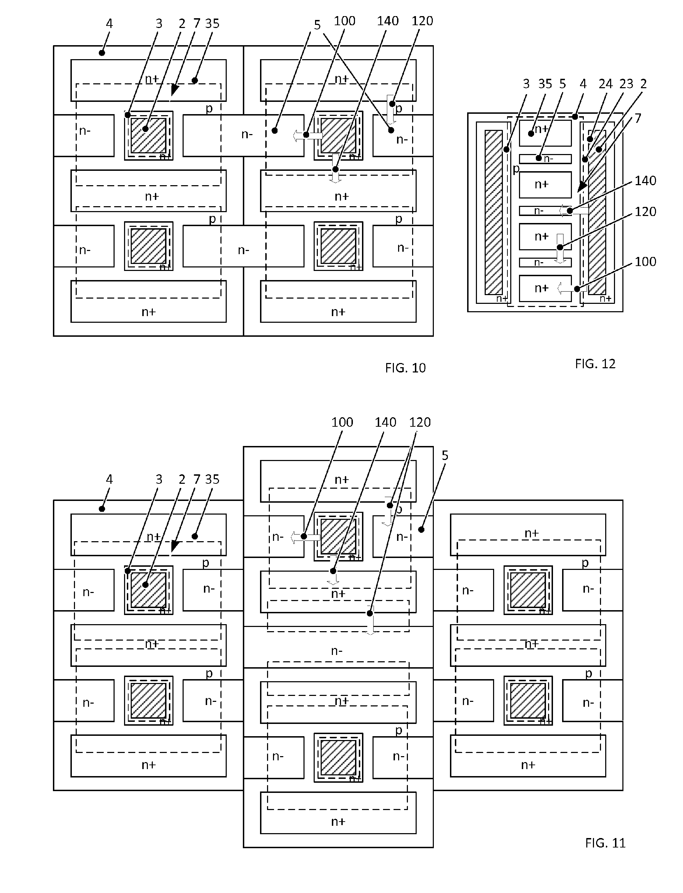

The emitter contact area 21 may comprise in a plane parallel to the emitter side 22 two second sides 24 opposite to each other, which second sides 24 are arranged perpendicular to the first sides 23. The MOS channel 140 may be formable at the two second sides 24 of the emitter contact area 21. Alternatively, the MOS channels 140 may also be formed at the same sides (i.e. the first sides 23) as and alternatingly to the IGBT channels 100 (as e.g. shown in the FIGs 12 to 14). The thyristor channel 120 may be formed in a plane parallel to the emitter side 22 parallel to the direction, in which the MOS channel 140 is formed, or perpendicular to that direction.

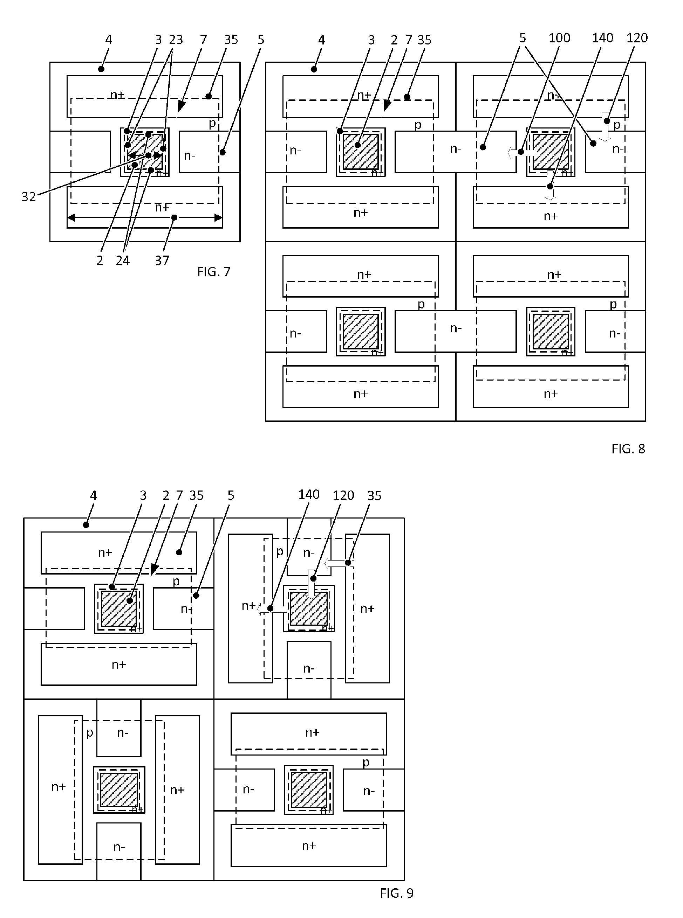

As shown in FIG 7, a unit may be formed by one emitter contact area 21, the surrounding first emitter layer 3, two second emitter layers 35 at the opposite second sides 24 of the emitter contact area 21, the base layer 4 and the drift layer at the two first sides 23. The semiconductor device 1 may comprise a plurality of such units, which are arranged in a regular manner. The units may be arranged in line to each other (FIG 8), each unit having the same orientation (first sides of a first unit is parallel to the first sides of the units neighbored to the first unit) or the units may be arranged such that they are rotated by 90° to each other so that the first sides of a first unit is perpendicular to the first sides of the units neighbored to the first unit (FIG 9).

Thus, in FIG 8 a plurality of emitter contact areas 21 are arranged in first rows with the first sides 23 arranged perpendicular to the first row, and a plurality of second emitter layers 35 are arranged in second rows parallel to the first rows. In the first row, no second emitter layers 35 are arranged, whereas in the second rows, no first emitter contact areas 21 or first emitter layers 3 are arranged. In between two first rows, one or two second rows may be arranged. If one second row is arranged in between, thyristor channels 120 are formable on two opposite sides of the second emitter layer 35, the sides being arranged parallel to the second side 24 (FIG 10). If two second rows are arranged in between, there may be just the base layer 4 extending to the emitter sided surface in between the two neighbored second emitter layers 35 belonging to different rows (FIG 8) or the drift layer 5 may also extend to the emitter sided surface in between two second emitter layers 35 belonging to the two neighbored second rows, so that another thyristor channel is formable from the second emitter layers 35 to the drift layer 4 in between two units.

For units arranged in line to each other, at the second sides 24 of two neighbored units, there may be either one second emitter layer 35 arranged between the two emitter contact areas 21 of the two neighbored units so that at the second emitter layer 35 IGBT channels 100 can be formed at two opposite sides of the second emitter layer 35 (FIG 10), i.e. the units overlap. Alternatively, there may be two second emitter layers 35 arranged in between (FIG 8). Between the two second emitter layers 35, the drift layer 5 may extend to the emitter sided surface of the wafer so that additional thyristor channels are formable (middle part of FIG 11; i.e. between the right and left part in FIG 11). Also shown in FIG 11 is that units may be shifted against each other, e.g. by half the size of the unit. However, the arrangement as shown in the middle part in FIG 11 may also be repeated at the left and right sides.

The first emitter layer 3 has a maximum first extension 32 in a plane parallel to the emitter side 22 and parallel to the second sides 24. The second emitter layer 35 has a maximum second extension 37 also in a plane parallel to the emitter side 22 and parallel to the second sides 24, which is larger than the first extension 32. Thus, the second emitter layer 35 projects the first emitter layer 3 on two opposite sides, i.e. both second sides 24. By such a projection, thyristor channels 120 are formable in a direction parallel to that of the IGBT channel 100.

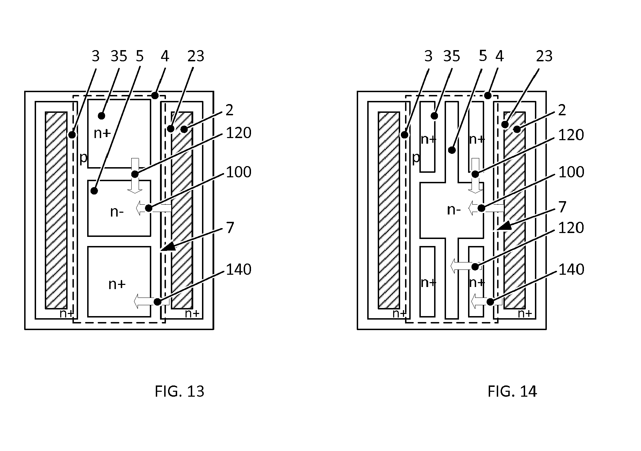

The emitter contact area 21 and the surrounding first emitter layer 3 may also be formed as a long strip, which extends over a plurality of second emitter layers 35, alternating with the base layer 4 and the drift layer 5 at the longer side of the strip (FIG 12). A strip shall mean that the layer has an extension (long side of the strip) in a first direction, which is larger than the extension of the strip in a second direction (short side of the strip) perpendicular to the first direction, e.g. at least two times, five times or ten times longer. In this case, the IGBT and MOS channel 100, 140 are formed in parallel, whereas the thyristor channel 120 may be formable perpendicular to the other two channels 100, 140. Thus, in a plane parallel to the emitter side 22 the plurality of second emitter layers 35 surrounded by the base layer 4 are arranged alternatingly with the drift layer 5 in a row and in the emitter contact area 21 neighbored to the row extends over the plurality of second emitter layers 35. The emitter contact area 21 may extend over only two second emitter layers 35 (FIG 13) or more second emitter layers 35 (FIG 12).

FIG 14 shows another inventive device in which the emitter contact area 21 and the surrounding first emitter layer 3 are again formed as a long strip, which extends over a plurality of second emitter layers 35. However, in this device the drift layer 5 is also formed as a strip extending over a plurality of second emitter layers 35, i.e. the strip is formed parallel to the strip of the first emitter layer 3, i.e. in the first direction, however which strip is overlaid with wider areas of the drift layer, so that wider areas and narrower areas (strip part) of the drift layer alternate in the first direction. In between the drift layer 5 and the first emitter layer 3, second emitter layers 35 are arranged on two sides of the drift layer 3 (along the long sides of the strip). However, in the wider areas of the drift layer, no second emitter layers 35 are arranged along the first direction and in which the drift layer 5 is separated from the first emitter layer 3 only by the base layer 4. In this area, in which the drift layer is wider than the short side of the strip, the IGBT channel 100 is formed. Thyristor channels 120 are formed from the second emitter layers 35 to the drift layer 5 in a direction parallel to the IGBT channel 100 (at an area of the drift layer 5, in which the drift layer 5 is formed as a pure strip) and another thyristor channel 120 is formed from the second emitter layer 35 to the wider area of the drift layer in the second direction, i.e. perpendicular to the other thyristor channel 120. Such wider and narrower areas of the drift layer 5 may be arranged repetitively in the device.

In another embodiment, the conductivity types are switched, i.e. all layers of the first conductivity type are p type (e.g. the drift layer 5) and all layers of the second conductivity type are n type (e.g. base layer 4).

It should be noted that the term "comprising" does not exclude other elements or steps and that the indefinite article "a" or "an" does not exclude the plural. Also elements described in association with different embodiments may be combined. It should also be noted that reference signs in the claims shall not be construed as limiting the scope of the claims.

It will be appreciated by those skilled in the art that the present invention can be embodied in other specific forms without departing from the spirit or essential characteristics thereof. The presently disclosed embodiments are therefore considered in all respects to be illustrative and not restricted. The scope of the invention is indicated by the appended claims rather than the foregoing description and all changes that come within the meaning and range and equivalence thereof are intended to be embraced therein.

### Reference List

- 1: semiconductor device
- 10: wafer
- 2: emitter electrode
- 21: emitter contact area
- 22: emitter side
- 23: first side
- 24: second side
- 25: collector electrode
- 27: collector side
- 3: first emitter layer
- 32: first extension
- 35: second emitter layer
- 37: second extension
- 39: connection layer
- 4: base layer
- 42: first base region
- 44: second base region
- 45: contact layer
- 5: drift layer
- 52: enhancement layer
- 55: buffer layer
- 6: collector layer
- 7: gate electrode
- 72: gate layer
- 73: first electrically conductive layer
- 735: second electrically conductive layer
- 74: insulating layer
- 100: IGBT channel
- 120: thyristor channel
- 140: MOS channel

## Claims

1. Power semiconductor device (1) comprising a wafer (10), on which wafer (10) an emitter electrode (2) is arranged on an emitter side (22) of the wafer and a collector electrode (25) is arranged on a collector side (27) of the wafer opposite to the emitter side (22),
wherein a planar gate electrode (7) is arranged on the emitter side (22), which gate electrode (7) comprises an electrically conductive gate layer (72) and an insulating layer (74), which insulates the gate layer (72) from any layer of a first or a second conductivity type, which is different from the first conductivity type, in the wafer (10),
wherein layers of the first and second conductivity type are arranged between the collector and emitter side (27, 22) in the following order:
a collector layer (6) of the second conductivity type,
a drift layer (5) of the first conductivity type,
a base layer (4) of the second conductivity type,
a first emitter layer (3) and a second emitter layer (35) of the first conductivity type,
wherein the first emitter layer (3) is separated from the drift layer (5) by the base layer (4) and wherein the emitter electrode (2) contacts the base layer (4) and the first emitter layer (3) at an emitter contact area (21),
wherein the second emitter layer (35) is separated from the drift layer (5) and from the first emitter layer (3) by the base layer (4) and wherein the second emitter layer (35) is insulated from a contact to the emitter electrode (2) by the insulating layer (74),
wherein an IGBT channel (100) is formable from the first emitter layer (3) via the base layer (4) to the drift layer (5),
wherein a thyristor channel (120) is formable from the second emitter layer (35) via the base layer (4) to the drift layer (5),
wherein a MOS channel (140) is formable from first emitter layer (3) via the base layer (4) to the second emitter layer (35).

2. Power semiconductor device according to claim 1, **characterized in that** the first emitter layer (3) is a closed layer surrounding the emitter contact area (21).

3. Power semiconductor device (1) according to claim 1 or 2, **characterized in that** an enhancement layer (52) of the first conductivity type is arranged between the base layer (4) and the drift layer (5), which enhancement layer (52) separates the base layer (4) from the drift layer (5), wherein the drift layer (5) has a constantly low doping concentration and wherein the enhancement layer (52) has a higher doping concentration than the drift layer (5).

4. Power semiconductor device according to any of the claims 1 to 3, **characterized in that** the emitter contact area (21) comprises in a plane parallel to the emitter side (22) two first sides (23) opposite to each other, wherein the IGBT channel (100) is formable at the two first sides (23) of the emitter contact area (21).

5. Power semiconductor device (1) according to claim 4, **characterized in that** the emitter contact area (21) comprises in a plane parallel to the emitter side (22) two second sides (24) opposite to each other, which second sides (24) are arranged perpendicular to the first sides (23), and **in that** the MOS channel (140) is formable at the two second sides (24) of the emitter contact area (21).

6. Power semiconductor device (1) according to any of the claims 1 to 5, **characterized in that** the first emitter layer (3) has a maximum first extension (32) in a plane parallel to the emitter side (22) and perpendicular to the first sides (23) and **in that**
the second emitter layer (35) has a maximum second extension (37) in a plane parallel to the direction, in which the first extension (32) is provided, wherein the second extension (37) is larger than the first extension (32).

7. Power semiconductor device (1) according to any of the claims 1 to 6, **characterized in that** the device (1) comprises a plurality of emitter contact areas (21), which are arranged in first rows with the first sides (23) arranged perpendicular to the first row, and a plurality of second emitter layers (35), which are arranged in second rows parallel to the first rows.

8. Power semiconductor device (1) according to claim 7, **characterized in that** one or two second rows is or are arranged between two first rows.

9. Power semiconductor device (1) according to claim 1 to 6, **characterized in that** in a plane parallel to the emitter side (22) a plurality of second emitter layers (35) surrounded by the base layer (4) are arranged alternatingly with the drift layer (5) in a row and **in that** the emitter contact area (21) neighbored to the row extends over at least two of the plurality of second emitter layers (35).

10. Power semiconductor device (1) according to any of the claims 1 to 6, **characterized in that** a unit is formed by one emitter contact area (21), the surrounding first emitter layer (3) and two second emitter layers (35) on the opposite second sides (24) of the emitter contact area (21) and **in that** the device (1) comprises a plurality of such units, wherein the units are arranged in a regular manner.

11. Power semiconductor device (1) according to claim 10, **characterized in that** in a plane parallel to the emitter side (22), the units are arranged in rows, wherein the two first sides (23) of the emitter contact areas (21) of each two neighbored units are arranged perpendicular to each other.

12. Power semiconductor device (1) according to claim 10, **characterized in that** in a plane parallel to the emitter side (22), the units are arranged in rows, wherein the two first sides (23) of the emitter contact areas (21) of each two neighbored units are arranged parallel to each other.

13. Power semiconductor device (1) according to any of the claims 1 to 12, **characterized in that** the base layer (4) comprises a first base region (42) having a first maximum doping concentration, which first base region (42) is arranged below the emitter contact area (21) and a second base region (44) having a second maximum doping concentration, which second base region (44) is arranged below the second emitter layer (35), wherein the first maximum doping concentration is higher than the second maximum doping concentration, in particular the first maximum doping concentration is between 1 * 10¹⁷ cm⁻³ and 1 * 10¹⁸ cm⁻³ and the second maximum doping concentration is between 1 * 10¹⁶ cm⁻³ and 1 * 10¹⁷ cm⁻³.

14. Power semiconductor module comprising at least two power semiconductor devices according to any of the claims 1 to 13, **characterized in that** the module comprises an electrically conductive connection layer (39), which electrically connects at least two second emitter layers (35) of the at least two power semiconductor devices with each other.
